# EUROPÄISCHE PATENTSCHRIFT

(11) **EP 0 658 967 B1**
(45) Veröffentlichungstag und Bekanntmachung des Hinweises auf die Patenterteilung: **10.09.1997**
(21) Anmeldenummer: 94117659.6
(22) Anmeldetag: 09.11.1994
(51) Int. Cl.: H02K 49/10, F04D 13/02, H02K 5/128, C23C 16/26

(54) **Magnetkreiselpumpe für aggressive medien**
Magnetic circulation pump for agressive fluids
Pompe de circulation magnétique pour fluides agressifs

(30) Priorität: 14.12.1993 DE 4342649
(43) Veröffentlichungstag der Anmeldung: 21.06.1995
(73) Patentinhaber: Munsch Kunststoff-Schweisstechnik GmbH, D-56221 Ransbach-Baumbach (DE)
(72) Erfinder: Munsch, Stefan, D-60486 Frankfurt/Main (DE)
(74) Vertreter: Goddar, Heinz J., Dr.

(56) Entgegenhaltungen:
- EP-A- 0 268 085
- US-A- 4 877 985
- US-A- 5 198 263

## Beschreibung

Die Erfindung betrifft eine Magnetkreiselpumpe für aggressive Medien mit einem Spalttopf zwischen einem mit Permanentmagneten bestückten Außenrotor, der mit einem Antriebsmotor verbunden ist, und einem mit Permanentmagneten bestückten Innenrotor, der mit einem Laufrad verbunden ist, wobei der Spalttopf aus einem Faserverbundstoff gefertigt ist.

Eine derartige Magnetkreiselpumpe ist beispielsweise aus der DE-PS 36 36 404 C2 bekannt. Der Spalttopf trennt dabei das aggressive Medium, das den Innenrotor mit umgibt, von dem Rest der Pumpe, insbesondere dem Außenrotor. Er kann aus verschiedenen Materialien bestehen. Beispielsweise sind Kunststoff-, Metall- und Keramikspalttöpfe bekannt.

Vollkunststofftöpfe können zwar gegenüber den aggressiven Medien unempfindlich gewählt werden, weisen dann jedoch materialbedingt eine zu hohe Elastizität auf, so daß sie den auftretenden Saugdrücken nicht standhalten können und sich verformen. Dies ist selbstverständlich unerwünscht, da dann der den Rotoren verbleibende Freiraum nicht mehr gewährleistet ist.

Metallspalttöpfe sind gegenüber den aggressiven Medien nicht unempfindlich genug. Sie müssen daher beschichtet werden. Dabei ist insbesondere problematisch, daß Keramikbeschichtungen oder Emaillebeschichtungen für eine gute Haftung der Beschichtung auf dem Metallspalttopf ein Erhitzen des Spalttopfes voraussetzen, was jedoch die Materialeigenschaften des Metalls erheblich beeinflußt, da diese Erhitzung bis zu einem Bereich von typischerweise 500°C führt, also einer Temperatur, bei der das Metall "angelassen" wird.

Weiter ist auch die Verwendung von Keramikspalttöpfen erprobt worden. Diese Töpfe sind jedoch nur sehr aufwendig auf die genauen Abmessungen dimensionierbar, müssen dicker sein und benötigen oft zusätzlich eine Gleitbeschichtung, da sonst die Gleitreibung zwischen Keramik und den anderen in der Magnetkreiselpumpe auftretenden Substanzen sehr hoch ist.

Meist behilft man sich daher mit zwei Spalttöpfen aus unterschiedlichen Materialien, die ineinander gesteckt werden, beispielsweise einem Außentopf aus Metall und einem Innentopf aus PTFE oder, wie in der oben erwähnten Druckschrift DE-PS 36 36 404 erwähnt, aus einem Außentopf aus GFK mit einem zusätzlichen Innentopf aus PTFE. Mit einer derartigen Ausgestaltung können aggressive Medien wirksam daran gehindert werden, mit dem Spalttopf zu reagieren, und gleichzeitig eine hohe Festigkeit gegen den Saugdruck erzielt werden.

Nachteilig an einer derartigen Ausgestaltung ist jedoch, daß die Dicke eines Spalttopfes und damit die magnetische Strecke zwischen Innenrotor und Außenrotor erheblich ist, daß PTFE nur schlecht die Wärme leitet, so daß sich aufgrund der unterschiedlichen Wärmeausdehnungskoeffizienten zwischen beiden Materialien Probleme ergeben. Durch die unterschiedlichen Temperaturausdehnungskoeffizienten kann bei bestimmten Temperaturverhältnissen ein mangelnder Kontakt zwischen beiden Töpfen auftreten, der die größeren Fertigungstoleranzen, die durch die Verwendung zweier Töpfe entstehen, unangemessen erhöht.

Der Erfindung liegt daher die Aufgabe zugrunde, eine Magnetkreiselpumpe mit einem dünnen Spalttopf zu versehen, der chemisch auch durch aggressive Medien nicht angreifbar ist, der die Gleitreibung zwischen Topf und den anderen in der Magnetkreiselpumpe auftretenden Substanzen möglichst weit herabsetzt, dabei mit möglichst geringem technischen Aufwand mit hoher Fertigungsgenauigkeit produziert werden kann, der die Wärme der oft heißen Medien gut leitet und bei dem es bei Wärmeeinwirkung keine Ausdehnungsprobleme gibt.

Erfindungsgemäß wird dies durch die im Hauptanspruch aufgefürten Merkmale erreicht.

Vorteil einer amorphen Kohlenstoffschicht auf einem kohlenfaserverstärkten Kunststoffspalttopf ist die geringe Dicke des Topfes, die bisher mit anderen Beschichtungen nicht realisierbar war, da diese nicht auf dem Kunststoff hafteten. Der Kunststoff muß erfindungsgemäß nicht, wie bisher nötig, auf Temperaturen von ca. 500° erhitzt werden um eine Beschichtung aufzubringen, was bei dem genannten Kunststoffmaterial eben nicht möglich ist, sondern man kann nach dem vorgeschlagenen Verfahren praktisch ohne größere Erhitzung - im Moment ist eine Erwärmung im Bereich von ungefähr 120° C, teilweise 60° C möglich - amorphen Kohlenstoff aufbringen.

Vorteilhaft ist weiter, daß der amorphe Kohlenstoff wärmeleitend ist, so daß kein wärmeleitendes Substrat aus z. B. Metall nötig ist. Es kann ein CFK-Spalttopf für die unterschiedlichsten Zwecke verwendet werden, auch für die, wo Wärme zu- oder abgeführt werden muß. Durch die extreme Verschleißfestigkeit des amorphen Kohlenstoffs kann weiter eine wesentlich dünnere Schicht als bei anderen denkbaren Beschichtungen aufgebracht werden, dünner insbesondere, als es die bisherigen PTFE-Töpfe waren.

Die dünne Schicht erlaubt, die vorhandene Geometrie eines hochgenau herstellbaren CFK-Topfes beizubehalten. Da auch kein nennenswerter Verschleiß auftritt, brauchen auch während des Betriebs keine entstehenden Verschleißtoleranzen befürchtet werden, die ansonsten schon bei der Konstruktion ihren Niederschlag finden müßte. Auch wird sich durch die gute Wärmeleitfähigkeit keine temperaturbedingte Geometrieänderung einstellen.

Vorteilhaft ist nicht zuletzt das spannungsfreie Aufbringung der Beschichtung auf den Kunststoff, sowie deren große Elastizität aufgrund der keine, insbesondere keine thermisch bedingten Spannungen zwischen den beiden Materialien auftreten.

Abschließend ist vorteilhaft, daß durch die durchsichtige Beschichtung weiter eine optische Kontrolle des CFK-Spalttopfes möglich ist.

Die in einer vorgeschlagenen Ausführung weiter vorteilhafte Beimengung eines Wasserstoffanteils in die Beschichtung trägt zur Amorphizität der Beschichtung bei. Ansonsten würde sich beim Beschichtungsvorgang, eventuell auch erst durch die dauerhafte mechanische oder thermische Belastung, eine der bereits bekannten kristallinen Formen des Kohlenstoffs in der Beschichtung ausbilden können. Dies ist unerwünscht. Es ist an einer dauerhaften Beibehaltung der amorphen Eigenschaften der Kohlenstoffbeschichtung gelegen.

Eine Dicke von mehr als 10 µm für die Beschichtung ist vorteilhaft, da so bei vorteilhafter dünner Beschichtung zur Erlangung kurzer magnetische Strecken, die beste Übermittlung von auftretenden Druckbelastungen durch die elastische amorphe Schicht hindurch auf den CFK-Spalttopf erfolgt. Zur Erlangung genügender Wärmeleitung in der Ebene der Beschichtung genügt erstaunlicherweise schon eine so dünne Schicht.

Vorteilhaft bei dieser Schichtdicke ist weiter die Unterstützung der Beschichtung in sich selbst zur Vermeidung eines Eisscholleneffektes, in der eine harte Beschichtung bricht, da sie nicht genügend durch das Trägermaterial unterstützt wird.

Weitere Vorteile und Merkmale der Erfindung werden in der nachfolgenden Beschreibung eines bevorzugten Ausführungsbeispiels, insbesondere des Verfahrens zum Herstellen der erfindungsgemäßen Beschichtung, ersichtlich. Dabei zeigt die begleitende Zeichnung:
- Fig. 1: eine Schnittdarstellung durch eine Magnetkreiselpumpe, in der der Spalttopf erkennbar ist, und
- Fig. 2: die Darstellung eines Spalttopfes aus einem CFK-Außen- und einem PTFE-Innentopf, und
- Fig. 3: den erfindungsgemäßen CFK-Spalttopf mit einer Innenbeschichtung, der verglichen mit dem der Fig. 2 insgesamt wesentlich dünner hergestellt werden kann.

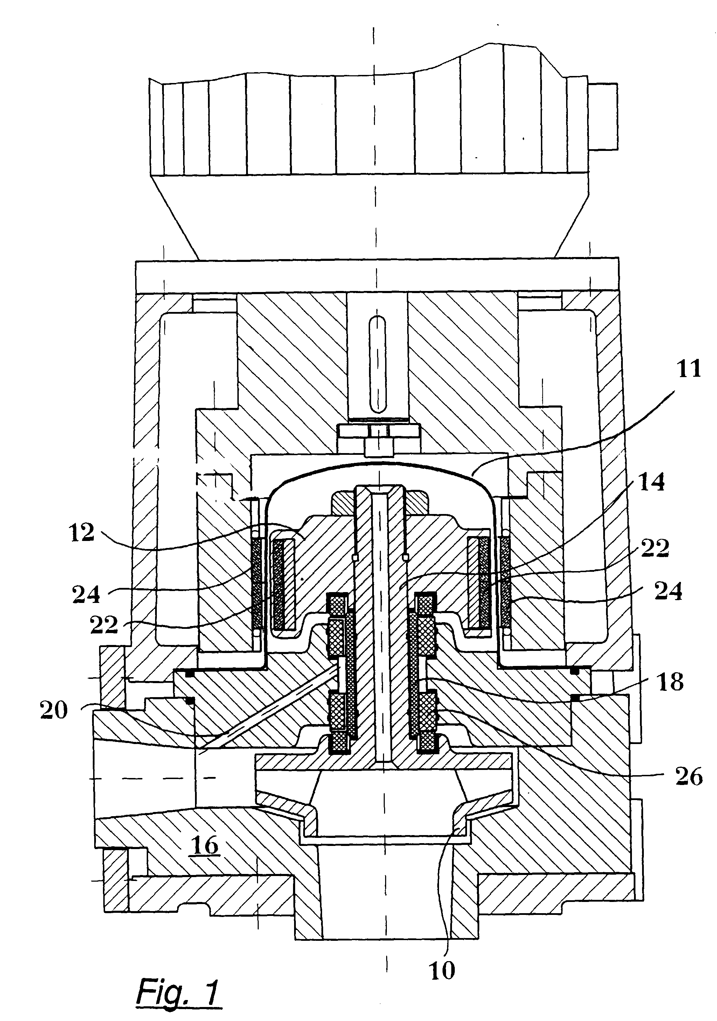

In der Fig. 1 ist eine Magnetkreiselpumpe mit einem Laufrad 10, einem Spalttopf 11, einer Welle 14, einem an der Welle befestigten Magnetinnenrotor 12 mit aufgesetzten Permanentmagneten 22 sowie den außerhalb des Spalttopfes 11 angeordneten Magneten 24 des Außenrotors zu erkennen.

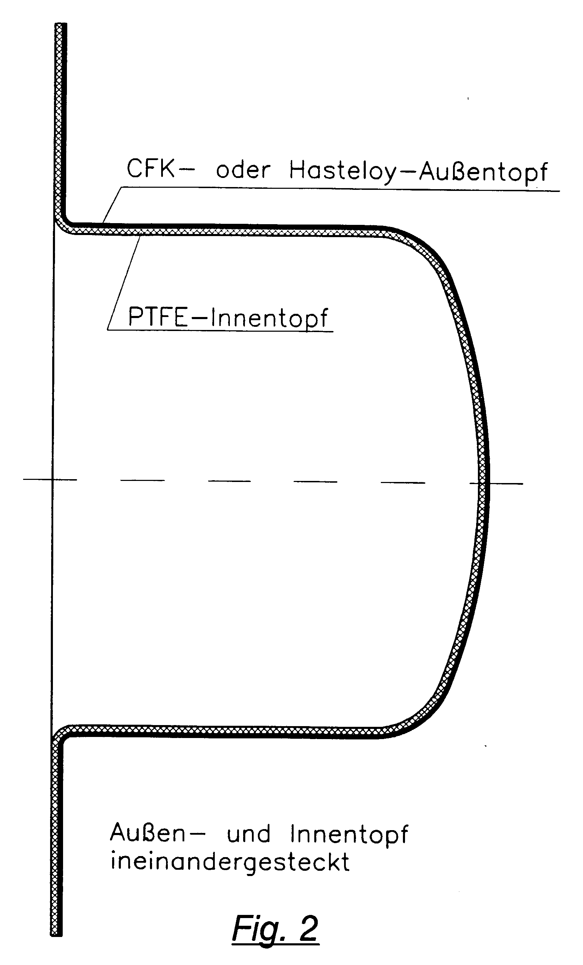

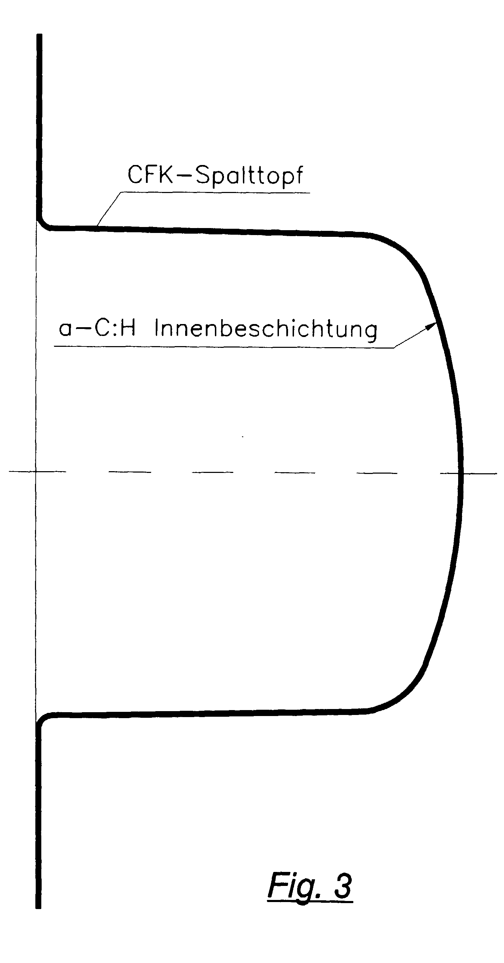

Die Vorsehung eines beschichteten Spalttopfes 11 wie er in der Fig. 3 dargestellt ist, anstelle eines separaten Kunststoff-Spalttopfes (z. B. wie in Fig. 2) zur Bedeckung eines gegenüber den aggressiven Medien empfindlichen weiteren Topfes hat insbesondere den Vorteil, daß die magnetische Strecke zwischen einem Außenrotor und einem Innenrotor bei der Magnetkreiselpumpe verringert werden kann. Damit können die magnetischen Kräfte besser übertragen werden, und die Verluste werden verkleinert. Die vorgeschlagene nichtmetallische Ausführung hat gegenüber einem metallischen Spalttopf den weiteren Vorteil, daß keine Wirbelströme in dem Spalttopf entstehen, die den Spalttopf unerwünscht erhitzen und zu Energieverlusten führen.

Gegenüber herkömmlichen Kunststofftöpfen kann der erfindungsgemäß beschichtete Kunststofftopf mit wesentlich dünneren Wandstärken hergestellt werden, einmal aufgrund der Beimengung von Kohlenstoffasern, die die Stabilität erhöhen, und zum anderen dadurch, daß die sehr harte Beschichtung außerordentlich fest mit dem Spalttopf verbunden ist.

Damit ergibt sich ein deutlich besserer Unterstützungseffekt der Beschichtung als durch einen separaten, zudem noch aus weicherem Kunststoff gefertigten Innentopf aus PTFE (Teflon).

Dennoch ist die Elastizität der Beschichtung auf kurzen Strecken im Vergleich zu deren Verschleißfestigkeit erstaunlich. Es kann eine Schicht in der Größenordnung einer Dicke von nur 2 µm gefertigt werden, die nicht durch die üblicherweise vorhandenen Bedingungen beschädigt werden kann. Durch diese dünne Schicht ist zudem eine hohe Wärmeleitung an den dahinterliegenden Spalttopf aus Kunststoff möglich. Damit ist gewährleistet, daß beide Materialien jeweils die gleiche Temperatur besitzen.

Eine Korrosion des amorphen Kohlenstoffes, wie sie bei herkömmlichen Materialien üblich ist, findet nicht statt. Sie kann nicht einmal in µm pro Betriebsjahr angegeben werden. Die sich daraus ergebende wesentlich verlängerte Lebensdauer bzw. dünnere Schichtdicke erlaubt synergistisch genauere Einhaltung der geometrischen Bedingungen und wiederum verringerten Verschleiß.

Weiter haftet die Beschichtung im Vergleich zu Emaille oder ähnlichen bisher bekannten Beschichtungen bereits bei sehr niedrigen Temperaturen. Diese Haftung ist derart gut, daß sie praktisch nicht gemessen werden kann.

Gelingt es einmal mit Hilfe eines Diamanten, Teile der Schicht abzulösen, haftet diesen Schichtteilen meist Substratmaterial an.

Wichtig ist jedoch, die Beschichtung auf eine saubere Oberfläche aufzubringen. Die Oberflächenbearbeitung vor der Beschichtung sollte daher besonders sorgfältig erfolgen.

Das Verfahren zur Herstellung eines erfindungsgemäßen Spalttopfes besteht darin, daß der einseitig offene Spalttopf 11 in eine hermetisch abschließbare Kammer eingebracht wird, wobei der Spalttopf mit seiner offenen Seite nach oben auf einen leitenden, gegenüber der Kammer isolierten Probenteller aufgesetzt wird, die Kammer mit einem Vakuumpumpstand evakuiert wird, dann ein kohlenwasserstoffhaltiges Gasgemisch (z.B. Butan) eingeleitet wird, bei gleichzeitiger weiterer Entleerung der Kammer, wobei zunächst ein Druck von ca. 10⁻⁵ mbar durch das Evakuieren erreicht wird, und sodann durch vermehrte Einleitung des Gases ein Druck von ca. 10⁻³ - 1 mbar gehalten wird. Dann wird durch Beaufschlagen des leitenden Probentellers mit einem starken Hochfrequenzsignal im Bereich von ca. 2 - 30 MHz ein Kohlenstoff-Wasserstoff-Plasma in einer dünnen Schicht um den Spalttopf erzeugt.

Aus dieser Plasmaschicht heraus lagert sich dann der amorphe Kohlenstoff ab. Die Schichtdicke des erzeugten Plasmas ist dabei stark druckabhängig. So wird sie bei einem Kammerdruck von 10⁻² mbar ungefähr 10 mm dick sein und nur 1/100 mm bei 10 mbar betragen. Je dünner die Schicht ist, umso feinere Konturen können geometrisch richtig beschichtet werden, während gleichzeitig die Bindungsfestigkeit aufgrund von Temperatur und Gasdruck zunimmt.

Die Temperatur der Kammer wird über den gesamten Beschichtungsvorgang mit ca. 100 - 120° C beibehalten.

Gegenüber den bisher bekannten Beschichtungen von (meist) Metalloberflächen, wie z. B. Beschichtungen mit Titannitrid, weist die erfindungsgemäße Beschichtung mit amorphem Kohlenstoff nicht nur eine hohe Widerstandsfähigkeit gegenüber Verschleißreibung auf, sie hat auch eine sehr niedrige Gleitreibung.

Bisher bekannte Beschichtungen, wie z. B. aus Titannitrid, die gegen abrasiven und adhäsiven Verschleiß schützen, tun dies durch mikroharte, d. h. gegen plastische Verformung widerstandsfähige bzw. im zweiten Fall gegen hohe Temperaturen widerstandsfähige Oberflächen. Ein Reiben von mikroskopisch kleinen Unebenheiten gegeneinander erfolgt dennoch, wobei sich das weichere der beiden reibenden Materialeien, meist Stahl, auf den Beschichtungen absetzt. Es ergibt sich dann eine Stahl-Stahl Reibung, die zwar die geschützte Oberfläche nicht beeinträchtigt, aber dennoch Wärme entwickelt.

Demgegenüber ermöglicht eine Beschichtung mit modifiziertem Kohlenstoff auch bei dauernd wiederkehrenden Wandpartnern verringerten Verschleiß. Bei amorphem Kohlenstoff werden sich statt einer Stahlanlagerung eher Kohlenstoffatome - obwohl diese sehr fest in ihrer Fläche angebunden sind - an den Stahl anlagern und eine Kohlenstoff-gegen-Kohlenstoff-Reibung verursachen, die wesentlich geringere Reibungskoeffizienten besitzt.

Eine derartige Kohlenstoff-gegen-Kohlenstoff-Reibung ergibt niedrigere Temperaturbelastung und ermöglicht daher wiederum dünnere Beschichtungen.

## Patentansprüche

1. Magnetkreiselpumpe für aggressive Medien mit einem Spalttopf (11), zwischen einem mit Permanentmagneten (24) bestückten Außenrotor, der mit einem Antriebsmotor verbunden ist, und
einem mit Permanentmagneten (22) bestückten Innenrotor, der mit einem Laufrad (10) verbunden ist,
wobei der Spalttopf (11) aus einem Faserverbundwerkstoff gefertigt ist,
gekennzeichnet durch
eine auf den Faserverbundwerkstoff durch Ionenbeschuß aufgebrachte Beschichtung aus modifiziertem, amorphen Kohlenstoff.

2. Magnetkreiselpumpe nach Anspruch 1, dadurch gekennzeichnet, daß der Spalttopf aus kohlefaserverstärktem Kunststoff (CFK) besteht.

3. Magnetkreiselpumpe nach einem der vorangehenden Ansprüche, dadurch gekennzeichnet, daß die Kohlenstoffschicht einen Wasserstoff-Anteil von ca. 20 - 30 Atomprozent aufweist.

4. Magnetkreiselpumpe nach einem der vorangehenden Ansprüche, dadurch gekennzeichnet, daß die aufgebrachte amorphe Schicht eine Dicke von mehr als 10 µm aufweist.

5. Verfahren zum Beschichten des Spalttopfs einer Magnetkreiselpumpe nach einem der vorangehenden Ansprüche, gekennzeichnet durch die Schritte
- Einbringen des einseitig offenen Spalttopfes (11) in eine hermetisch abschließbare Kammer, wobei der Spalttopf mit seiner offenen Seite nach oben auf einen leitenden, gegenüber der Kammer isolierten Probenteller aufgesetzt wird,
- Evakuieren der Kammer mit einem Vakuumpumpstand,
- Einleiten eines kohlenwasserstoffhaltigen Gasgemisches bei gleichzeitiger weiterer Entleerung der Kammer, wobei zunächst ein Druck von ca. 10⁻⁵ mbar durch das Evakuieren erreicht wird, und sodann durch vermehrte Einleitung des Gases ein Druck von ca. 10⁻³ - 1 mbar beibehalten wird,
- Beaufschlagen des leitenden Tellers, auf dem sich der Spalttopf (11) befindet, mit einem starken Hochfrequenzsignal, wobei die Hochfrequenz im Bereich von ca. 2 - 30 MHz gesteuert wird, und
- Kontrollieren der Temperatur der Kammer über den gesamten Beschichtungsvorgang zu einer konstante Temperatur von ca. 100 - 120 ° C.

## Claims

1. A magnetic centrifugal pump for aggressive media comprising a separating can (11), between an outer rotor which is equipped with permanent magnets (24) and which is connected to a drive motor, and
an inner rotor which is equipped with permanent magnets (22) and which is connected to an impeller (10),
the separating can (11) being made from a fibre composite,
characterised by
a coating of modified amorphous carbon which is applied to the fibre composite by ion bombardment.

2. A magnetic centrifugal pump according to claim 1, characterised in that the separating can consists of carbon fibre reinforced plastic.

3. A magnetic centrifugal pump according to any one of the preceding claims, characterised in that the carbon coating has a hydrogen content of about 20 to 30 atom-percent.

4. A magnetic centrifugal pump according to any one of the preceding claims, characterised in that the amorphous coating applied has a thickness of more than 10 µm.

5. A method of coating the separating can of a magnetic centrifugal pump according to any one of the preceding claims, characterised by the following steps:
- introduction of the separating can (11) open at one end, into a hermetically sealable chamber, the separating can being fitted with its open end at the top on to a conductive sample plate insulated from the chamber,
- evacuating the chamber with a vacuum pump system,
- introduction of a hydrocarbon-containing gas mixture with simultaneous further emptying of the chamber, an initial pressure of about 10⁻⁵ mbar being achieved by the evacuation, and a pressure of about 10⁻³ - 1 mbar then being maintained by increased introduction of the gas,
- subjecting the conductive plate on which the separating can (11) is located to a strong highfrequency signal, the high frequency being controlled in the range from about 2 to 30 MHz and
- controlling the temperature of the chamber throughout the coating operation to a constant temperature of 100 - 120°C.

## Revendications

1. Pompe centrifuge magnétique pour fluides agressifs, avec un pot à entrefer (11), placé entre un rotor extérieur, équipé d'aimants permanents (24), et relié à un moteur d'entraînement, et
avec un rotor intérieur, équipé d'aimants permanents (22) et relié à une roue mobile (10),
le pot à entrefer (11) étant fabriqué en un matériau composite à fibres,
caractérisée par un revêtement, appliqué sur le matériau composite à fibres par bombardement ionique et réalisé en un carbone amorphe modifié.

2. Pompe centrifuge magnétique selon la revendication 1, caractérisée par le fait que le pot à entrefer est constitué d'une matière synthétique renforcée par des fibres de carbone (CFK).

3. Pompe centrifuge magnétique selon l'une des revendications précédentes, caractérisée par le fait que la couche de carbone présente une proportion d'hydrogène d'environ 20 à 30 pour-cent d'atomes.

4. Pompe centrifuge magnétique selon l'une des revendications précédentes, caractérisée par le fait que la couche amorphe appliquée a une épaisseur supérieure à 10 µm.

5. Procédé de revêtement du pot à entrefer d'une pompe centrifuge magnétique selon l'une des revendications précédentes, caractérisée par les étapes consistant à:
- introduire le pot à entrefer (11) ouvert d'un côté, dans une chambre pouvant être fermée de façon hermétique, le pot à entrefer étant appliqué par son côté, ouvert vers le haut sur un plateau d'essai conducteur, isolé vis-à-vis de la chambre,
- vider la chambre avec un groupe de pompage sous vide,
- introduire un mélange de gaz contenant un hydrocarbure, tout en continuant simultanément à vider la chambre, en atteignant d'abord une pression d'environ 10⁻⁵ mbar par la mise sous vide, puis en conservant une pression d'environÿ10⁻³ à 1 mbar, en procédant à une introduction répétée du gaz,
- exposer le plateau conducteur, sur lequel se trouve le pot à entrefer (11), à un signal haute fréquence fort, la haute fréquence étant régulée dans la plage d'environ 2 à 30 MHz, et
- contrôler la température de la chambre sur la totalité du processus de revêtement pour réguler une température constante, d'environ 100 à 120°C.
